Europäisches Patentamt

European Patent Office

Office européen des brevets

(19)

(11) **EP 0 982 818 A2**

(12) **EUROPÄISCHE PATENTANMELDUNG**

(43) Veröffentlichungstag:
   **01.03.2000  Patentblatt 2000/09**

(51) Int Cl.7: **H01S 3/0941**, H01S 5/40

(21) Anmeldenummer: **99113961.9**

(22) Anmeldetag: **17.07.1999**

(84) Benannte Vertragsstaaten:
   **AT BE CH CY DE DK ES FI FR GB GR IE IT LI LU
   MC NL PT SE**
   Benannte Erstreckungsstaaten:
   **AL LT LV MK RO SI**

(30) Priorität: **25.08.1998  DE 19838518**

(71) Anmelder: **ROBERT BOSCH GMBH
   70442 Stuttgart (DE)**

(72) Erfinder:
   • **Maurer, Dieter
   71522 Backnang (DE)**
   • **Bartelt-Berger, Lars
   71570 Oppenweiler (DE)**
   • **Hauer, Heiner
   70734 Fellbach (DE)**
   • **Kuke, Albrecht
   71549 Auenwald (DE)**
   • **Moess, Eberhard
   71540 Murrhardt (DE)**

(54) **Laseranordnung**

(57)   Anordnung zur Ausrichtung der beiden strahlengänge des Laserlichts von zwei Laserdioden (2) auf einen gemeinsamen Fleck, insbesondere für die Bereitstellung von Pumplicht für einen Festkörperlaser.

Beide Strahlengänge weisen jeweils zwischen der betreffenden Laserdiode (2) und dem Fleck durch Reflexion einen Knick auf.

Jeweils in einem Strahlengang zwischen einer der Laserdioden (2) und dem zugehörigen Knick ist eine Zylinderlinse (9) vorgesehen.

Jeweils im Strahlengang zwischen einem Knick und dem gemeinsamen Fleck ist eine von zwei Linsen (14) vorgesehen.

Wenigstens eine der Linsen (14) ist lateral so justiert, dass sich die beiden Strahlengänge im Fleck vereinigen.

Die Laserdioden (2), die Zylinderlinsen (9) und die Linsen (14) sind auf einem gemeinsamen Trägersubstrat (1) montiert.

Fig. 3b

EP 0 982 818 A2

**Beschreibung**

Stand der Technik

Die Erfindung geht von der Gattung aus, wie im unabhängigen Anspruch 1 angegeben.

Ein besonders effektives Verfahren zum Pumpen von Festkörperlasern besteht darin, anstelle der üblicherweise verwendeten Lampen Halbleiterlaserdioden (LD) zu verwenden, deren Emissionsspektrum wesentlich schmaler als das von Lampen ist und deren Wellenlänge so gewählt wird, dass sie gerade mit der Pumplichtwellenlänge des zu pumpenden Festkörperlasers zusammenfällt. Nach dem Stand der Technik sind verschiedene Anordnungen von Laserdioden bezüglich des zu pumpenden Festkörperlaserkristalls gebräuchlich.

Bei der transversalen Anordnung wird das Pumplicht quer zum Laserstrahl des Festkörperlasers in den Laserkristall eingestrahlt. Diese Art der Ankopplung hat den Vorteil, dass viele Pumplaserdioden über die Länge des Laserkristalls hinweg angeordnet werden können und daher die Gesamtpumpleistung und damit auch die Laserleistung erhöht werden kann. Das Lasersystem wird dadurch in seiner Leistung skalierbar, d.h. die Laserleistung wächst proportional zur Anzahl der auf der Länge des Laserkristalls angebrachten Laserdioden. Nachteilig hierbei ist, dass der gesamte Querschnitt des Laserkristalls vom Pumplicht durchstrahlt wird. Dabei geht Pumpleistung in Bereichen des Laserkristalls verloren, in denen kein Laserlicht erzeugt wird. Anderseits wird durch einen zu großen Querschnitt des gepumpten Lasermaterials eine Anregung von transversal höheren Moden ermöglicht, die bei denjenigen Anwendungsfällen nicht erwünscht sind, bei denen eine Laserstrahlung im transversalen Grundmodus TEM00 benötigt wird.

Bei der longitudinalen Pumpanordnung wird das Pumplicht in Richtung des zu pumpenden Laserstrahls des Festkörperlasers eingekoppelt. Bei dieser Art der Anregung lässt sich das Pumplicht genau auf das Volumen konzentrieren, in dem der Laserstrahl verläuft. Dadurch wird einerseits der Einkoppelwirkungsgrad zwischen Pumplicht und Laserlicht gegenüber der transversalen Ankopplung wesentlich verbessert und andererseits kann ein so kleiner Querschnitt gepumpt werden, dass nur der transversale Grundmodus TEM00 angeregt wird. Die Möglichkeiten zur Pumplichteinkopplung mittels einer größeren Anzahl von Pumplichtquellen sind hier jedoch gegenüber der transversalen Pumpanordnung beschränkt. Das Pumplicht kann über den vorderen und/oder den hinteren Laserspiegel eingekoppelt werden. Hierbei ist mindestens einer der Laserspiegel dichroitisch verspiegelt, d.h. diese Fläche ist für das Laserlicht reflektierend und für das Pumplicht transparent. Bei plattenförmigen Laserkristallen, in denen das Laserlicht in einem gefalteten Strahlengang an den Seitenflächen des Kristalls reflektiert wird, kann auch von dort das Pumplicht in Richtung des Laserstrahls eingekoppelt werden, sofern die Reflexion an diesen Stellen nicht eine Totalreflexion ist. Die Einkoppelstellen für das Pumplicht müssen dichroitisch beschichtet sein.

Da für den Pumpeffekt die Polarisationsrichtung des Lichtes nicht von Bedeutung ist, können an jeder dieser Einkoppelstellen zwei Pumplichtquellen mit gekreuzten Polarisationsrichtungen über je einen Polarisationsstrahlungskombinierer zusammengeführt werden. Insgesamt bedeutet diese Anordnung der Pumplichtquellen jedoch einen erheblichen Aufwand durch die jeweils erforderlichen Einkoppeloptiken und die Strahlkombinierer, die in der gesamten Peripherie des Laserkristalls verteilt angeordnet werden müssen. Daher wurden nach dem Stand der Technik bereits weitere Vorschläge gemacht, wie diese Nachteile vermindert werden können. Hierbei wurde ausgenutzt, dass geringe Abweichungen in den Strahlausbreitungsparametern von Pumplicht und Laserlicht möglich sind, da das Pumplicht im Laserkristall im Gegensatz zum Laserlicht stark absorbiert wird, so dass bei einer Fokussierung des Pumplichtes in den Laserkristall die meiste Pumpenergie innerhalb des Fokusbereichs absorbiert wird. Dadurch ist es möglich, dass über einen der oben genannten Pumplichteingänge mehrere Laserdioden einstrahlen können. Voraussetzung ist hierbei jedoch, dass die einzelnen Laserstrahlen nur sehr geringe Abweichungen in ihrer Einstrahlrichtung und in ihrem Einstrahlpunkt haben. Erschwerend kommt hinzu, dass die benötigten leistungsstarken Pumplaserdioden eine stark elliptische Strahltaille mit einer Breite von typischerweise 100 um und einer Höhe von typischerweise 1 µm haben und dementsprechend mit einer elliptischen Abstrahlcharakteristik mit einer vertikalen Ausdehnung von typischerweise 40° und einer horizontalen Abstrahlung von typischerweise 10° strahlen. Zur Strahlformung werden wegen der Elliptizität der Strahltaille der Pumpstrahlen zylindrische oder anamorphotische Abbildungskomponenten benötigt. Hierzu wurden nach dem Stand der Technik verschiedene Vorschläge mit kompliziert im Raum angeordneten Spiegeln und Prismen gemacht (siehe z.B. US-Patent Nr. 5,557,475). Die zusammengeführten Einzelstrahlen der Pumplaserdioden können dann entweder direkt in den Laserkristall eingekoppelt werden oder über eine Lichtleitfaser mit Stufenprofilkern und ausreichendem Kerndurchmesser (≥200 µm) eingekoppelt und zum Laserkristall geführt werden. Nachteilig an den bekannten Vorschlägen ist, dass hierbei eine große Anzahl von komplizierten optischen Bauteilen verwendet werden muß, die einzeln und mit hoher Präzision im Raum justiert und montiert werden müssen, wobei zu einer stabilen Montage aufwendige Halterungen erforderlich sind.

Vorteile der Erfindung

Der Anmeldungsgegenstand mit den Merkmalen des Anspruches 1 hat folgenden Vorteil:
Ausgehend von diesem Stand der Technik werden mit der Anordnung nach der vorliegenden Erfindung die oben beschriebenen Nachteile vermieden und es wird eine einfache und automatisierbare Justage und Montage der Laserdioden, insbesondere Pumplaserdioden und der zugehörigen optischen Komponenten ermöglicht.

Vorteilhafte Weiterbildungen sind in den abhängigen Ansprüchen angegeben, deren Merkmale auch, soweit sinnvoll, miteinander kombiniert werden können.

Zeichnungen

Ein Ausführungsbeispiel der Erfindung ist in den Zeichnungen dargestellt und im Folgenden näher erläutert. Schematisch ist gezeigt in

Figur 1:  eine Anordnung von Laserdioden, insbesondere Pumplaserdioden in Aufsicht,
Figur 2:  dieselbe Anordnung im Querschnitt,
Figur 3a:  eine Detailskizze in Aufsicht,
Figur 3b:  eine zugehörige Skize im Querschnitt,
Figur 4:  ein Beispiel für den gesamten Strahlengang einer erfindungsgemäßen Anordnung,
Figur 5:  eine Anordnung in einem hermetisch dichten Gehäuse mit Faseranschluss.

Im Wesentlichen gleiche Teile in unterschiedlichen Figuren sind mit gleichen Bezugszeichen versehen.

Beschreibung des Ausführungsbeispiels

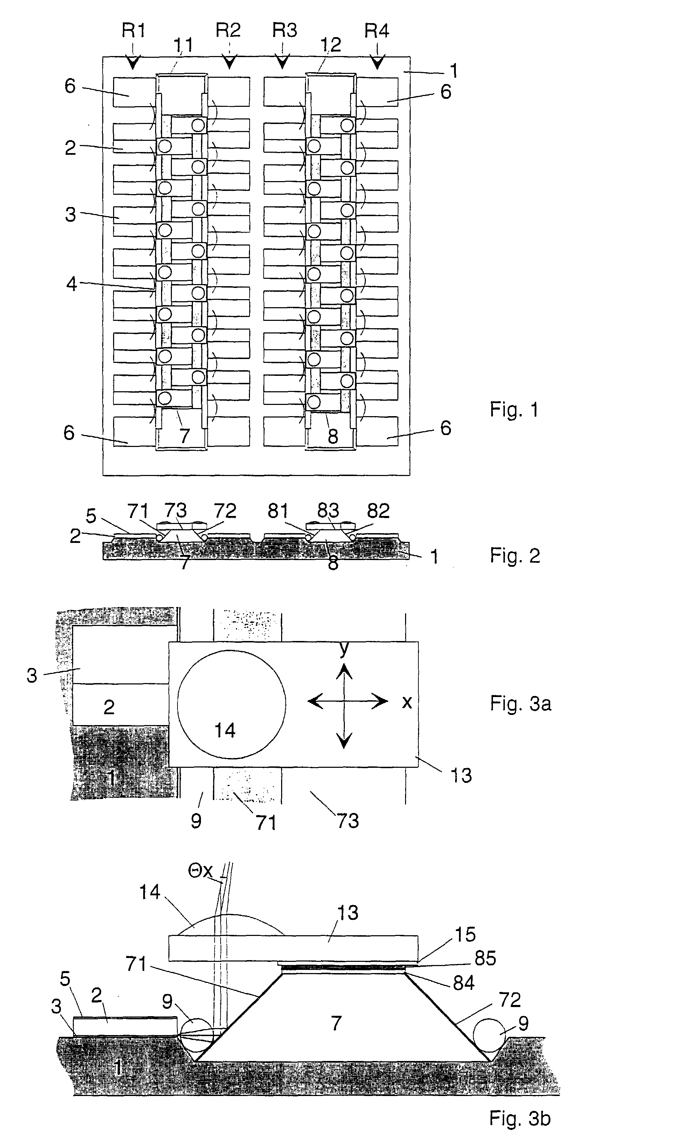

Figur 1 zeigt eine erfindungsgemäße Anordnung von Laserdioden, insbesondere Pumplaserdioden in Aufsicht, Figur 2 im Querschnitt. Auf einem Trägersubstrat 1, das zur Ableitung der Verlustwärme aus einem Material mit guter Wärmeleitfähigkeit hergestellt ist, sind Laserdioden 2 in bis zu vier Reihen R1 bis R4 nebeneinander angeordnet. Zur elektrischen Kontaktierung sitzen die Laserdioden mit ihrer unteren Anschlussseite auf je einer Kontaktfläche 3, die größer ist als die Grundfläche einer Laserdiode und die gegenüber dem Trägersubstrat 1 isoliert ist, falls dieses aus einem elektrisch leitfähigen Material besteht. Die Laserdioden 2 können auf diese Weise elektrisch in Reihe geschaltet werden. Die Hintereinander schaltung der Laserdioden erfolgt dabei über Bondverbindungen 4 von der oberen Kontaktseite 5 einer jeden Laserdiode zur Kontaktfläche 3, auf welche die benachbarte Laserdiode montiert ist. Die Anschlüsse der Laserdioden an den Enden einer jeden Reihe werden auf Anschlussflächen 6 geführt, auf welche die Stromzuführung von der äußeren Beschaltung gelegt wird (hier nicht gezeichnet). Auch eine Parallelschaltung aller Laserdioden 2 einer Reihe ist möglich, wenn entsprechende Leiterbahnen für die Stromzuführung für die oberen Kontaktflächen auf dem Trägersubstrat 1 vorgesehen werden (hier nicht gezeichnet). Das Trägersubstrat 1 kann der Boden eines Gehäuses (in den Figuren 1 und 2 nicht gezeichnet) für den hermetisch dichten Einschluss der Gesamtanordnung der Pumplaserdioden sein, damit diese vor Umwelteinflüssen geschützt werden und somit ihre Lebensdauer und Zuverlässigkeit erhöht wird. Ebenso kann das Trägersubstrat 1 auch auf den Boden eines solchen Gehäuses aufgelötet werden. In beiden Fällen kann die Verlustwärme mit geringem Wärmewiderstand auf eine unter dem Gehäuseboden großflächig angebrachte Wärmesenke abgeführt werden und somit eine unzulässige Temperaturerhöhung der Pumplaserdioden vermieden werden.

In dem in den Figuren 1 und 2 gezeigten Ausführungsbeispiel sind je sieben Laserdioden in vier Reihen R1 bis R4 angeordnet. Die Laserdioden der Reihen R1 und R2 sowie der Reihen R3 und R4 strahlen dabei jeweils gegeneinander . Zwischen den Reihen R1 und R2 sowie zwischen R3 und R4 ist je ein prismatischer Spiegelkörper 7 beziehungsweise 8 angebracht, dessen Seitenflächen verspiegelt sind und gegenüber einer Flachseite des Trägersubstrates 1 eine Neigung von 45° haben. Das auf diesen Spiegelflächen 71, 72, 81 und 82 seitlich auftreffende Licht der Laserdiodenreihen R1, R2, R3 und R4 wird dabei nach oben abgelenkt. Bei Laserdioden, die so montiert sind, dass die Lichtaustrittsfläche wie gezeigt unten liegt (episide down), muss die Spiegelfläche bis unter die Unterseite des Laserdioden-Chips reichen. Hierzu können die Laserdioden auf einen Zwischenträger aufgelötet werden, der auf dem Trägersubstrat 1 montiert wird (hier nicht gezeichnet), oder die prismatischen Spiegelkörper 7 und 8 werden in Vertiefungen 11 und 12 montiert. Wählt man als Material für den Trägerkörper 1 einkristallines Silizium, so können die Vertiefungen 11 und 12 durch einen bekannten anisotropen Ätzprozess hergestellt werden. Die Spiegelkörper 7, 8 können dann durch einen bekannten anodischen Bondprozess mit dem Trägersubstrat 1 verbunden werden. Bei anderen Materialien für das Trägersubstrat und die Spiegelkörper können andere Verfahren zur Strukturierung der Vertiefungen 11 und 12 (beispielsweise Prägen, Erodieren oder Fräsen) und zum Befestigen der Spiegelkörper (beispielsweise Kleben oder Löten) eingesetzt werden.

Zur Umformung des stark divergenten Strahls der Laserdioden 2 in einen schwach konvergenten Strahl ist für jede Laserdiode eine Abbildungsoptik erforderlich. Gebräuchliche Hochleistungslaserdioden haben ein stark elliptisches Fernfeld, das über eine Zylinderlinse in ein zirkularsymmetrisches Fernfeld umgewandelt werden kann. Die Zylinderlinse muss dabei in geringem Abstand zur Laserdiode und parallel zur langen Achse des elliptischen Lasernahfeldes ausgerichtet sein. Wie die Figuren 1 bis 3 zeigen, ist für alle Laserdioden 2 einer Reihe eine gemeinsame stabförmige Zylinderlinse 9 verwendet. Die Zylinderlinsen für jede der vier Laserreihen werden in die V-förmige Lücke zwischen den Seitenwänden von Vertiefungen 11 und 12 und schrägen Spiegelflächen 71, 72, 81, 82 auf jede Seite der prismatischen Spiegelkörper 7 und 8 justagefrei eingelegt und fixiert. Je nach der erforderlichen Größe, Form und Position einer Zylinderlinse können auch spezielle Aufnahmen für die Zylinderlinsen im Trägersubstrat 1 durch bekannte Verfahren wie z.B. anisotropes Ätzen hergestellt werden. Die Zylinderlinse 9 wird in ihrer Brennweite und Apertur so dimensioniert, dass der transformierte Strahl einer jeden Laserdiode in vertikaler Richtung nahezu die gleiche Divergenz wie in horizontaler Richtung erhält. Der durch die gemeinsame Zylinderlinse nahezu zirkularsymmetrisch transformierte und nur noch schwach divergente Laserstrahl trifft auf eine der Spiegelflächen 71, 72, 81 oder 82 und wird nach oben umgelenkt. Auf der flachen Oberseite 73 bzw. 83 des prismatischen Spiegelkörpers 7 bzw. 8 wird für jeden Laserstrahl ein Linsenhalter 13 mit einer sphärischen Linse 14 aufgelegt. Der Linsenhalter 13 liegt dabei mit seinem flachen Teil auf der Oberseite 73 bzw. 83, und der Teil des Linsenhalters, der die Linse 14 trägt, ragt mit dieser über die Seitenfläche 71, 72 ,81, 82 in den Laserstrahl (siehe Detailskizze Figuren 3a und 3b im Querschnitt beziehungsweise in Aufsicht). Aus Platzgründen können dabei, wie in Fig. 1 gezeigt, jeweils abwechselnd ein Linsenhalter nach links und ein Linsenhalter nach rechts ausgerichtet sein, wenn die Laserdiodenchips in benachbarten Reihen entsprechend versetzt zueinander angeordnet sind. Zur Fixierung eines Linsenhalters 13 auf dem prismatischen Spiegelkörper 7 bzw. 8 wird dessen flache Oberseite 73 bzw. 83 mit einer Metallisierungsschicht 84 und einer Lotschicht 85 versehen. Ebenso wird die Unterseite des Linsenhalters im Bereich der Auflagezone mit einer lotbenetzbaren Schicht 15 versehen, wobei die Lotschicht auch auf dem Linsenhalter aufgebracht sein kann.

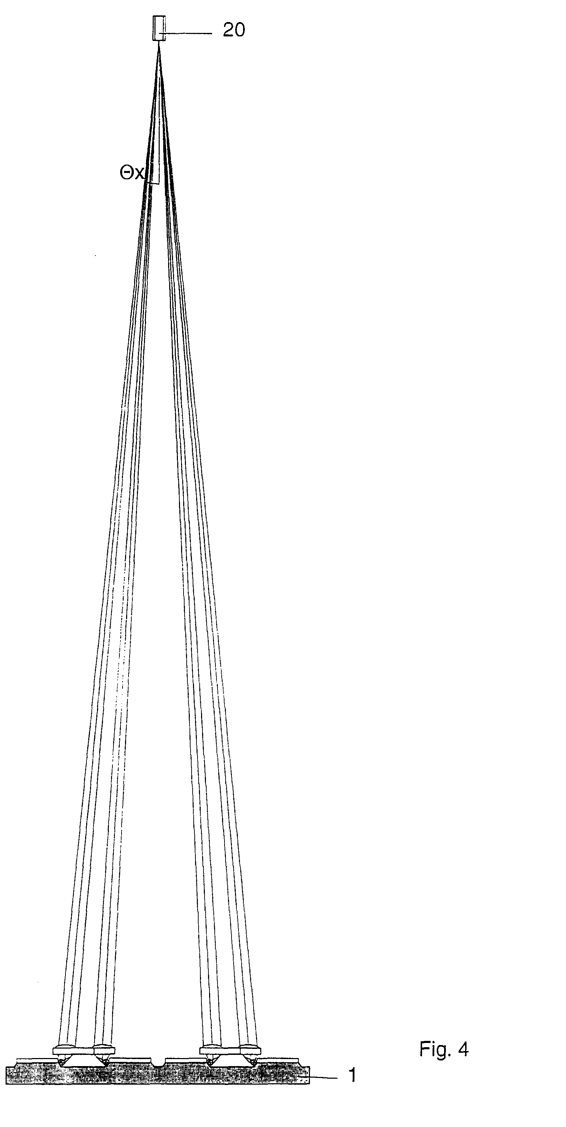

Der Abstand der Linse 14 von der zugehörigen Laserdiode 2 und die Brennweite der Linse 14 werden so gewählt, dass ein vergrößertes Bild des Lasernahfeldes in einem Abstand b von der Linse 14 entsteht (vgl. Figur 4). In der Ebene im Abstand b in Strahlungsrichtung hinter der Linse 14 wird die Stirnfläche einer optischen Faser 20, insbesondere einer Stufenprofilfaser mit einem Kernradius $r_k$ angebracht. Die Brennweite der Linse 14 allein bestimmt zusammen mit der Gegenstandsweite $g_p$ zwischen der Linse 14 und der Laserstirnfläche der Laserdiode 2 die Vergrößerung $V_p$ der Abmessung der Strahlungsquelle in der Ebene parallel zur Epitaxieschicht der Laserdiode. Die Abmessung der Strahlungsquelle in der Ebene senkrecht hierzu wird von der Zylinderlinse 9 und der Linse 10 mit dem Vergrößerungsverhältnis $V_s$ in der gleichen Bildebene im Abstand b von der Linse 14 abgebildet. Die Vergrößerungen $V_p$ und $V_s$ werden dabei so gewählt, dass die Halbachsen des Bildes der Laserstrahltaille im Abstand b von der Linse 14 kleiner sind als der Radius $r_k$ der

Faser 20. In diesem Fall kann das gesamte Licht aus einer Laserdiode 2 in die Faser 20 gelenkt werden. Damit das Licht in der Faser auch geführt werden kann, darf der maximale Einstrahlwinkel $\Theta_{max}$ nicht größer sein als der Akzeptanzwinkel $\Theta$ der Faser 20. Der maximale Einstrahlwinkel $\Theta_{max}$ ergibt sich aus der Bildweite b und der maximalen Ausdehnung der Laseranordnung auf dem Träger 1. Wählt man beispielsweise vier Laserreihen mit je sieben Laserdioden von je 1 mm Länge, so lassen sich diese, wie in Figur 1 dargestellt, so anordnen, dass die nach oben umgelenkten Strahlen aus einer Fläche von 4,4 mm · 6,6 mm austreten. Der größte Abstand $a_{max}$ eines Strahls von der Flächenmitte ist dann

$$a_{max} = \tfrac{1}{2} \cdot (4,4^2 + 6,6^2)^{1/2} \text{ mm} = 4 \text{ mm}.$$

Bei einer Stufenprofilfaser mit einer numerischen Apertur von NA = 0,2 und einem Kernradius von $r_k$ = 100 µm ist der Akzeptanzwinkel

$$\Theta = \arcsin (NA) = 11,5°.$$

Die Bildweite b muss in diesem Fall also mindestens

$$b_{min} = 4 \text{ mm} / \tan (11,5°) = 20 \text{ mm}$$

betragen.

Durch laterales Verschieben jeder Linse 14 relativ zu jeder dazugehörigen Laserdiode 2 kann der Strahl um einen kleinen Winkel $\Theta_x$ (Figur 3b) und $\Theta_y$ in x- und y-Richtung (Figur 3a) abgelenkt werden. Damit lässt sich der Strahl jeder einzelnen Pumplaserdiode in den Kern der Faser 20 richten. Auf diese Weise können die Linsen 14 von allen Pumplaserdioden der erfindungsgemäßen Anordnung einzeln nacheinander justiert werden. Die Linsenträger 13 werden dabei vorzugsweise durch ein automatisches Justagesystem lateral auf der Oberseite 73 bzw. 83 des Spiegelträgers 7 bzw. 8 verschoben, während die in die Faser 20 eingekoppelte Lichtleistung gemessen wird. Die Laserdiode, deren Strahlung gerade justiert wird, wird dabei einzeln mit Kontaktnadeln auf den jeweils benachbarten Kontaktflächen 3 kontaktiert. Anstelle der optischen Faser 20 kann an deren Position bei der Durchführung der Justage auch eine CCD-Kamera ohne Objektiv mit einem Strahldiagnosesystem angebracht werden. Ein solches System ist in der Lage, die Position des Schwerpunktes der Lichtverteilung auf dem Kamerachip zu bestimmen. Die Positionskoordinaten können dann direkt zur Steuerung der Linsenverschiebung genutzt werden, so dass der Justageprozess ohne einen aufwendigen Suchvorgang durchgeführt werden kann.

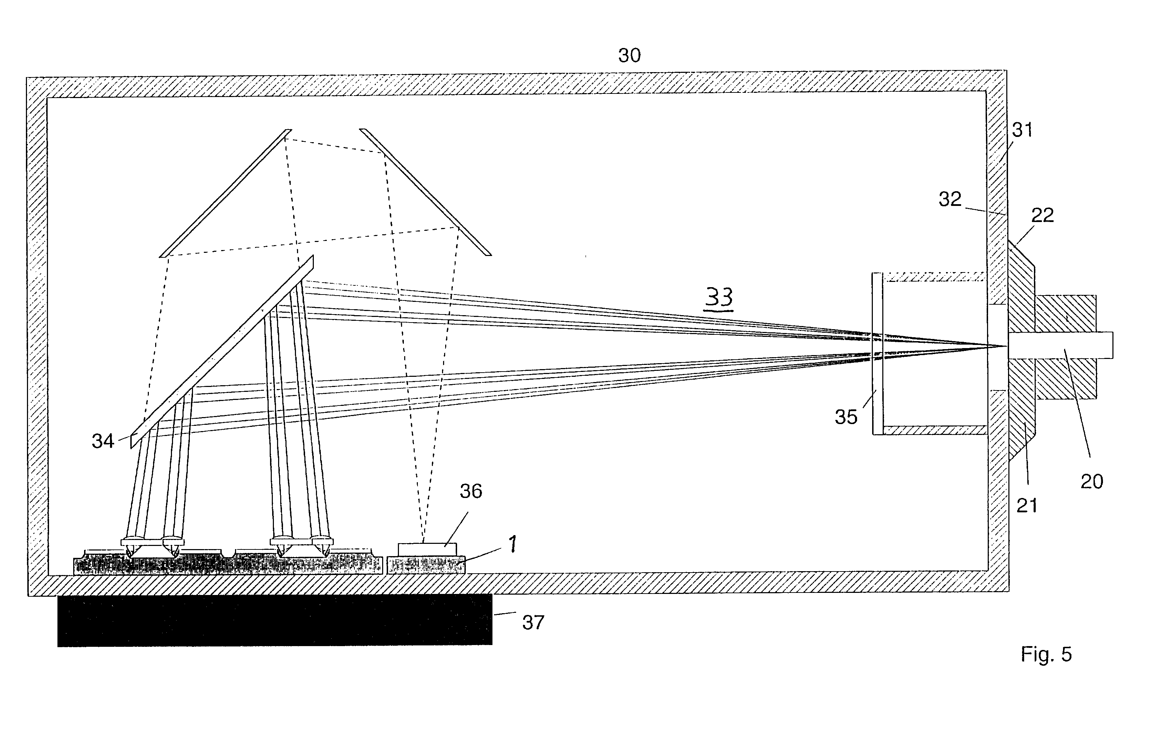

Figur 5 zeigt die erfindungsgemäße Anordnung in einem gemeinsamen hermetisch dichten Gehäuse 30 mit Faseranschluss. Die Faser 20 steckt dabei in einem Flansch 21 mit einer ebenen Flanschfläche 22. Das Gehäuse hat an einer Seitenfläche 31 ebenfalls eine ebene Flanschfläche 32. Das aus allen Einzelstrahlen bestehende Gesamtlichtbündel 33 wird in dem in Figur 5 gezeigten Ausführungsbeispiel an einem Spiegel 34 um 90° umgelenkt. Dies hat den Vorteil, dass die Faser 20 parallel zur Grundfläche des Trägersubstrates 1 geführt werden kann und somit die Gesamtanordnung weniger Platz beansprucht. Der hermetisch dichte Abschluss des Gehäuses 30 wird an der Lichtaustrittstelle in der Wand 31 durch ein Fenster 35 erreicht. Wenn der Umlenkspiegel 34 noch eine (wenn auch im Vergleich zum Reflexionsvermögen geringe) Transmission besitzt, so kann das transmittierte Licht als Monitorsignal für die Gesamtheit aller Pumplaserdioden verwendet werden. Im Ausführungsbeispiel nach Figur 5 wird es hierzu nochmals umgelenkt und auf eine Monitordiode 36 gerichtet. Unterhalb des Trägersubstrates 1 ist unter dem Gehäuseboden zur Abfuhr der Verlustwärme eine Wärmesenke 37 angebracht.

Die Position des Spiegels 34 und der Laseranordnung wird so gewählt, dass der Fokus des Gesamtlichtbündels 33 gerade in die Flanschebene der Flanschflächen 32 bzw. 22 und damit in die Stirnfläche der Faser 20 fällt. Montagetoleranzen des Spiegels 34 lassen sich dann nach dem Geamtlichtsignal bei Betrieb aller Pumplaserdioden durch eine aktive laterale Justage des Flansches 21 in der Ebene 32 ausgleichen. Das in die Faser 20 eingekoppelte Licht kann nun an die Pumplichteinkoppelstelle des zu pumpenden Festkörperlasers geführt werden.

**Patentansprüche**

1. Anordnung zur Ausrichtung der beiden Strahlengänge des Laserlichts von zwei Laserdioden (2) auf einen gemeinsamen Fleck,
   dadurch gekennzeichnet,

   - dass beide Strahlengänge jeweils zwischen der betreffenden Laserdiode (2) und dem Fleck durch Reflexion einen Knick aufweisen,
   - dass jeweils in einem Strahlengang zwischen einer der Laserdioden (2) und dem zugehörigen Knick eine Zylinderlinse (9) vorgesehen ist,
   - dass jeweils im Strahlengang zwischen einem Knick und dem gemeinsamen Fleck eine von zwei Linsen (14) vorgesehen ist,
   - dass wenigstens eine der Linsen (14) lateral so justiert ist, dass sich die beiden Strahlengänge im Fleck vereinigen,
   - dass die Laserdioden (2), die Zylinderlinsen (9) und die Linsen (14) auf einem gemeinsamen Trägersubstrat (1) montiert sind.

2. Anordnung nach Anspruch 1, dadurch gekennzeichnet, dass beide Zylinderlinsen (9), die zu den beiden in einer Linie nebeneinander liegenden Laserdioden (2) gehören, zu einer gemeinsamen Zylinderlinse (9) vereinigt sind.

3. Anordnung nach Anspruch 1 oder 2, dadurch gekennzeichnet, dass die Laserdioden (2) auf gleichem Niveau montiert sind.

4. Anordnung nach einem der vorangehenden Ansprüche, dadurch gekennzeichnet, dass die Linsen (14) auf gleichem Niveau montiert sind.

5. Anordnung nach einem der vorangehenden Ansprüche, dadurch gekennzeichnet, dass die Knicke auf einer gemeinsamen Reflexionsebene liegen.

6. Anordnung nach einem der Ansprüche 1 bis 4, dadurch gekennzeichnet, dass die Knicke auf jeweils einer von zwei Reflexionsebenen liegen, die symmetrisch zu einer Symmetrieebene angeordnet sind, die senkrecht auf den Strahlungsrichtungen der Laserdioden (2) steht.

7. Anordnung nach Anspruch 6, dadurch gekennzeichnet, dass auf jeder Seite der Symmetrieebene wenigstens zwei Laserdioden (2) in jeweils einer Linie angeordnet sind, die parallel zur Symmetrieebene verläuft.

8. Anordnung nach einem der vorangehenden Ansprüche, dadurch gekennzeichnet, dass zur Erzeugung wenigstens eines der Knicke eine Reflexionsfläche (71, 72, 81, 82) an einem prismatischen Spiegelkörper (7, 8) vorgesehen ist, der auf dem Trägersubstrat (1) montiert ist.

9. Anordnung nach Anspruch 8, dadurch gekennzeichnet, dass wenigstens eine der Zylinderlinsen (9) in einer V-Nut liegt, die durch eine der Reflexionsflächen (71) und eine Seitenfläche einer Vertiefung (11, 12) gebildet ist, die sich neben einer Laserdiode (2) in der diese tragenden Flachseite des Trägersubstrats (1) befindet.

10. Anordnung nach Anspruch 9, dadurch gekennzeichnet, dass die Vertiefung (11, 12) durch Ätzen ausgehoben ist.

11. Anordnung nach Anspruch 9 oder 10, dadurch gekennzeichnet, dass der Spiegelkörper (7, 8) auf dem Grund der Vertiefung (11, 12) oder auf einer Stufe innerhalb der Vertiefung montiert ist.

12. Anordnung nach einem der vorangehenden Ansprüche, dadurch gekennzeichnet, dass der Strahlengang zwischen der Linse (14) und dem gemeinsamen Fleck mit Hilfe einer Reflexionsfläche geknickt ist.

**13.** Anordnung nach einem der vorangehenden Ansprüche, dadurch gekennzeichnet, dass sich der gemeinsamen Fleck auf der Stirnfläche einer optischen Faser (20) befindet.

**14.** Anordnung nach einem der vorangehenden Ansprüche, dadurch gekennzeichnet, dass sie von einem hermetisch dichten Gehäuse (30) umgeben ist, durch dessen Wand die optische Faser (20) geführt ist.

Fig. 1

Fig. 2

Fig. 3a

Fig. 3b

Fig. 4

Fig. 5